# EUROPÄISCHE PATENTSCHRIFT

(11) **EP 0 408 841 B1**
(45) Veröffentlichungstag und Bekanntmachung des Hinweises auf die Patenterteilung: **13.11.1996**
(21) Anmeldenummer: 90107517.6
(22) Anmeldetag: 20.04.1990
(51) Int. Cl.: H03H 7/40

(54) **Schaltungsanordnung zum automatischen Abstimmen eines Anpassungsnetzwerks**
Circuit device for automatically tuning a matching network
Circuit d'accord automatique d'un circuit d'adaptation

(30) Priorität: 18.07.1989 DE 3923662
(43) Veröffentlichungstag der Anmeldung: 23.01.1991
(73) Patentinhaber: Balzers und Leybold Deutschland Holding Aktiengesellschaft, 63450 Hanau (DE)
(72) Erfinder: Gesche, Roland, Dr., D-6453 Seligenstadt (DE); Locher, Stefan, D-8755 Alzenau (DE)
(74) Vertreter: Schickedanz, Willi, Dipl.-Ing.

(56) Entgegenhaltungen:
- EP-A- 0 047 354
- US-A- 3 537 010
- US-A- 3 919 644
- US-A- 4 679 007

## Beschreibung

In Anlagen zum Aufbringen und Abtragen von dünnen Schichten hat die Plasmaerzeugung mittels Hochfrequenz weite Verbreitung gefunden. Dabei muß die variable Impedanz des Plasmas auf die feste Lastimpedanz eines 13,56 MHz-Hochfrequenzgenerators, die beispielsweise 50 Ohm beträgt, transformiert werden. Zu diesem Zweck sind Anpassungsnetzwerke üblich, die zwischen dem Hochfrequenzgenerator und der Plasmastrecke angeordnet sind. Diese Anpassungsnetzwerke weisen variable Spulen und/oder Kondensatoren auf, die mit der Hand verstellt werden, um eine Anpassung vorzunehmen.

Da die manuelle Einstellung der Kapazitäten bzw. Induktivitäten an den Kondensatoren bzw. Spulen umständlich ist, wurden auch schon automatische Anpassungsnetzwerke vorgeschlagen. Bei der Realisierung dieser Netzwerke treten jedoch verschiedene Probleme auf, die nur schwer lösbar sind. Beispielsweise ist ein Meßwertaufnehmer erforderlich, mit dem man bei hohen Leistungen eine komplexe Impedanz messen kann. Diese aus der vektorieilen Hochfrequenzmeßtechnik bekannten Meßwertaufnehmer sind sehr aufwendig und in dem bei der Plasmabeschichtung auftretenden Leistungsbereich derzeit nicht erhältlich. Insbesondere ist hierbei die Strommessung problematisch. Die Verwendung von Richtkopplern scheidet ebenfalls aus, weil hierfür die Frequenz von 13,56 MHz zu niedrig ist.

Es wäre auch denkbar, die Plasmaimpedanz selbst zu messen und daraus die notwendigen Verstellungen der Kapazitäten bzw. Induktivitäten zu berechnen Die Messung der Plasmaimpedanz ist jedoch noch problematischer als die Messung der Eingangsimpedanz des Anpassungsnetzwerks, da durch den Leistungs- und Impedanzbereich die Anforderungen an die Meßgenauigkeit und Dynamik extrem groß werden. Außerdem wäre für die Berechnung ein nicht unbeträchtlicher numerischer Aufwand nötig.

Aus den erwähnten Gründen wird im allgemeinen die Eingangsimpedanz gemessen und direkt zur Regelung verwendet. Da die Kennfelder jedoch von der Plasmaimpedanz abhängen, ist das Regelverhalten ebenfalls von der Plasmaimpedanz abhängig. Hinzu kommt, daß die Kennfelder auch nicht eindeutig sind, weshalb die Regler bei manchen Plasmaimpedanzen überhaupt nicht funktionieren.

Es ist indessen auch eine als Bandpaßfilter ausgebildete Anpassungsschaltung bekannt, mit der bei Frequenzwechsel oder auch bei Veränderung an einer Antenne eine Variation von Anpaßelementen im richtigen Sinne bewirkt wird (DE-B-19 15 760). Hierbei werden die Spannungen an mindestens zwei Parallelresonanzkreisen und ein Querstrom durch die koppelnde Längsimpedanz gemessen. Die der Anpassungsschaltung zugrundeliegende Regellogik geht davon aus, daß die beiden Resonanzkreise durch ein die Phase um 90 Grad - oder ein ungerades Vielfaches davon - drehendes Netzwerk gekoppelt sind. Der Aufwand am Resonanzkreis ist jedoch bei Einrichtungen, die nur anpassen, aber nicht filtern sollen, sehr hoch. Für Plasmaanwendungen, bei denen sehr große Impedanzunterschiede auftreten, ist die bekannte Anpassungsschaltung nicht geeignet.

Weiterhin ist auch ein Hochfrequenzgenerator mit einem automatischen Anpassungsnetzwerk bekannt, über dessen Funktionsweise jedoch keine näheren Angaben gemacht sind (Dual Reactor In-Line Plasma System, in: Solid State Technology, April 1983, Bd. 26, H. 4, S. 79 - 80, Fig. 4).

Ferner ist ein Verfahren zum Regeln eines Plasmaprozesses bekannt, bei dem die Impedanzänderung der Hochfrequenzleistung angezeigt wird (US-A-4 207 137). Hierbei ist ein Impedanzaufnehmer als Phasen- und Betragsdetektor ausgeführt. Dieser Aufnehmer weist induktive Stromaufnehmer auf, die nur schwer vor kapazitiven Einkopplungen geschützt werden können. Eine automatische Anpassung wird durch den Impedanzaufnehmer nicht erzielt.

Bei einer anderen bekannten Anpassungsschaltung für die Zuführung von hochfrequenter elektromagnetischer Energie auf eine variable Impedanz sind mehrere abstimmbare Kondensatoren und abstimmbare Induktivitäten vorgesehen (US-A-4 679 007). Hierbei werden induktiv arbeitende Aufnehmer und Phasenauswertungen verwendet, die Nachteile aufweisen.

Schließlich ist auch ein automatischer Antennenkoppler bekannt, der ein System verwendet, bei dem der reelle Teil einer komplexen Impedanz oder Admittance gemessen wird, der von einer Antenne oder einem anderen Netzwerk bereitgestellt wird (US-A-3 919 644). Als Meßwertaufnehmer werden hierbei ein induktiver Stromwandler und ein kapazitiver Spannungsaufnehmer verwendet.

Der Erfindung liegt die Aufgabe zugrunde, die Eingangsimpedanz einer Anpassungsschaltung für eine sich verändernde Lastimpedanz ohne technisch kritische Strommessungen zu messen und zu Regelungszwecken zu verwenden.

Diese Aufgabe wird gemäß den Merkmalen des Patentanspruchs 1 gelöst.

Der mit der Erfindung erzielte Vorteil besteht insbesondere darin, daß nur zwei Spannungen gemessen werden und ein dem Strom proportionales Signal aus der Spannungsdifferenz gebildet wird, wodurch keine direkte Strommessung erforderlich ist. Weiterhin werden die Regelgrößen aus den Beträgen der drei Signale gebildet, so daß Phasenmessungen entfallen. Dadurch wird ein preiswerter und zuverlässiger Aufbau der Meßaufnehmer und der Auswerteschaltung möglich. Außerdem erfolgt die Regelung weitgehend amplitudenabhängig.

Ein Ausführungsbeispiel der Erfindung ist in der Zeichnung dargestellt und wird im folgenden näher beschrieben. Es zeigen:
- Fig. 1: eine Anpassungsschaltung für eine variable Lastimpedanz mit einer zugehörigen Regelschaltung; und
- Fig. 2: eine Anordnung für die Erzeugung von Regelgrößen aus den gemessenen Größen.

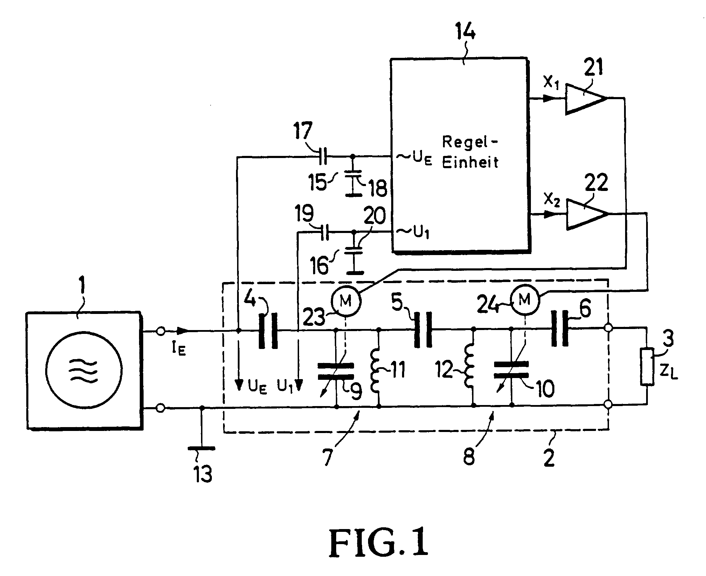

In der Fig. 1 ist ein Hochfrequenzgenerator 1 dargestellt, der auf einer Frequenz von 13,56 MHz schwingt und über ein Anpassungsnetzwerk 2 mit einer variablen Lastimpedanz 3 in Verbindung steht. Das Anpassungsnetzwerk 2 weist drei Kondensatoren 4, 5, 6 im Längszweig und zwei Parallelschwingkreise 7, 8 im Querzweig auf. Diese Schwingkreise 7, 8 bestehen aus jeweils einem variablen Kondensator 9 bzw. 10 und einer festen Spule 11 bzw. 12, wobei der Schwingkreis 8 mit seinem einen Anschluß an Masse 13 und mit seinem anderen Anschluß zwischen den Kondensatoren 5 und 6 liegt, während der andere Schwingkreis 7 mit seinem einen Anschluß ebenfalls an Masse 13 liegt, aber mit seinem anderen Anschluß mit den Kondensatoren 4 und 5 in Verbindung steht.

An der Anpassungsschaltung 2 werden zwei verschiedene Größen abgegriffen und einer Regeleinheit 14 zugeführt. Es handelt sich bei diesen Größen um die Spannung U_{E}, die am Ausgang des Hochfrequenzgenerators 1 ansteht, sowie um die Spannung U₁, die am Parallelschwingkreis 7, anliegt. Diese Spannungen U_{E} und U₁ werden über kapazitive Spannungsteiler 15, 16, die jeweils zwei Kondensatoren 17, 18 bzw. 19, 20 enthalten, der Regeleinheit 14 zugeführt, welche die beiden Regelgrößen x₁ und x₂ abgibt. Diese Regelgrößen x₁ und x₂ werden in Verstärkern 21, 22 verstärkt und auf Stellmotore 23, 24 gegeben, welche eine Verstellung der Kondensatoren 9 bzw. 10 vornehmen. Die Kondensatoren 9, 10 werden dabei so verstellt, daß das Anpassungsnetzwerk 2 stets einen Widerstandswert Z_{Esoll} einnimmt, der dem Innenwiderstand des Hochfrequenzgenerators entspricht. Im Anpassungsfall muß Z_{E} reell sein und 50 Ohm betragen. Daraus ergibt sich die Anpassungsbedingung für Z₁ₛₒₗₗ, also den Widerstandswert, der bei U₁ auftreten soll, zu 50 Ohm minus der Impedanz des Festkondensators 4. Da diese komplex ist, liefern die Beträge der beiden Impedanzen eine Aussage über Real- und Imaginärteil des Reflexionsfaktors bzw. der Eingangsimpedanz.

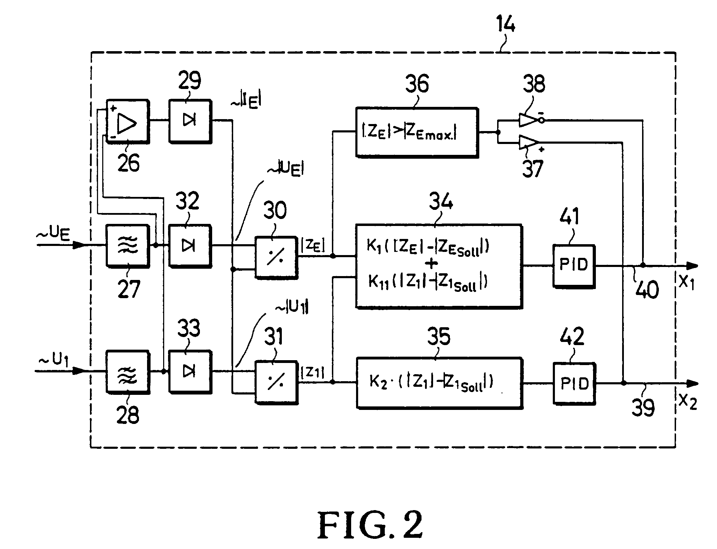

In der Fig. 2 ist die prinzipielle Funktionsweise der Regeleinheit 14 näher dargestellt. Man erkennt dort, daß die Signale _{∼}U_{E} und _{∼} U₁ jeweils einem Bandpaßfilter 27, 28 zugeführt sind. Die Übertragungsfunktionen dieser Filter 27, 28 und die Übertragungsfunktionen der Spannungsteiler 15, 16 sind hierbei phasengleich, was durch einen entsprechenden Abgleich leicht durchführbar ist. Die Ausgangssignale der beiden Bandpaßfilter 27 und 28 werden auf einen Subtrahierer 26 gegeben, dem ein Gleichrichter 29 nachgeschaltet ist, dessen Ausgangssignal zwei Dividierern 30, 31 zugeführt ist. Weiterhin wird das Ausgangssignal des Bandpaßfilters 27 einem Gleichrichter 32 zugeführt, dessen Ausgang mit einem zweiten Eingang des Dividierers 30 in Verbindung steht. Das Ausgangssignal des Bandpaßfilters 28 gelangt zudem über einen Gleichrichter 33 auf einen zweiten Eingang des Dividierers 31, dessen Ausgangssignal wiederum zwei Regelgrößen-Bildnern 34 und 35 zugeführt ist. Auf einen dritten Regelgrößen-Bildner 36 wird lediglich das Ausgangssignal des Dividierers 30 gegeben. Das Ausgangssignal dieses Regelgrößen-Bildners 36 wird auf einen Normalverstärker 37 und auf einen Umkehrverstärker 38 gegeben und von dort einem Ausgang 39 bzw. 40 zugeführt. Dagegen werden die Ausgangssignale der Regelgrößen-Bildner 34, 35 über jeweils einen PID-Regler 41 bzw. 42 den Ausgängen 40 bzw. 39 zugeführt. An diesen Ausgängen 39, 40 stehen dann die Regelgrößen x₁, x₂ an, die auf die Stellmotoren 23, 24 gegeben werden, wie es die Fig. 1 zeigt.

Das Gleichstromsignal, welches aus dem Gleichrichter 32 kommt und das zum Betrag der Eingangsspannung U_{E} proportional ist, wird in dem Dividierer 30 durch ein Gleichstromsignal dividiert, welches dem Betrag des Eingangsstroms I_{E} proportional ist. Hierdurch ergibt sich am Ausgang des Dividierers 30 ein Signal |Z_{E}|, welches dem Betrag der Eingangsimpedanz entspricht. Auf entsprechende Weise wird das Signal, welches dem Betrag der Spannung U₁ proportional ist, im Dividierer 31 durch das Signal dividiert, welches dem Betrag des Eingangsstroms I_{E} proportional ist. Am Ausgang des Dividierers 31 erscheint deshalb ein Signal |Z₁|, das dem Betrag einer Impedanz entspricht, welche der Differenz der Eingangsimpedanz minus der Impedanz des Kondensators 4 entspricht. Durch die Ermittlung der Impedanzen |Z_{E}| und |Z₁| wird die Regelung weitgehend amplitudenunabhängig.

In den Regelgrößen-Bildnern 34, 35 werden die Impedanzsignale |Z_{E}| und |Z₁| weiter bearbeitet, und zwar wird im Regelgrößen-Bildner 34 die Differenz zwischen |Z_{E}| und einem Sollwert von Z_{E} gebildet. Dieser Sollwert |Z_{Esoll}| entspricht einer Eingangsimpedanz, wie sie im Normalbetrieb auftritt. Die Differenz zwischen dem Istwert und dem Sollwert von Z_{E} zeigt somit eine Regelabweichung an. Diese Regelabweichung kann mit einem konstanten Faktor K₁ multipliziert werden, um sie besser weiterverarbeiten zu können. Des weiteren wird im Regelgrößen-Bildner 34 die Differenz zwischen der Impedanz |Z₁| und einer Sollimpedanz von Z₁ gebildet. Diese Differenz kann wieder mit einem Proportionalitätsfaktor K₁₁ multipliziert werden. Addiert man nun beide Differenzsignale, so erhält man eine Gesamtregelabweichung, die den beiden Einzelregelabweichungen entspricht. Diese Gesamtregelabweichung optimiert die Regelwege. Mit Hilfe des PID-Reglers 41 wird nun der Stellmotor 23 abgestimmt, der seinerseits den Kondensator 9 solange verstellt, bis die Gesamtregelabweichung im Regelgrößen-Bildner 34 Null ist.

Im Regelgrößen-Bildner 35 wird ebenfalls eine Differenz aus Soll- und Istwert gebildet, und zwar zwischen dem Soll- und Istwert von |Z₁|, wie er auch schon im Regelgrößen-Bildner 34 gebildet wurde. Anders als dort wird hier jedoch der Differenzwert mit einem Proportionalitätsfaktor K₂ multipliziert. Die auf diese Weise gebildete Regelabweichung wird auf den PID-Regler 42 gegeben, der den Stellmotor 24 ansteuert. Der Stellmotor 24 verstellt hierauf den Kondensator 10 solange, bis die Regelabweichung |Z₁|-Z₁ₛₒₗₗ| zu Null wird.

In dem Regelgrößen-Bildner 36 wird festgestellt, ob der Betrag der Eingangsimpedanz |Z_{E}| größer als ein vorgegebener Maximalwert dieser Eingangsimpedanz ist. Ist dies der Fall, so werden die mit einer relativ großen Zeitkonstanten behafteten PID-Regler 41, 42 gewissermaßen von den Signalen aus dem Regelgrößen-Bildner 36 überholt, d.h. es wird eine vorrangige Einstellung der Kondensatoren 9 und 10 vorgenommen, und zwar in dem Sinn, daß der Kondensator 9 auf kleinere Kapazitätswerte heruntergefahren und der Kondensator 10 auf größere Kapazitätswerte hochgefahren wird. Die gegenläufige Steuerung der beiden Kondensatoren 9 und 10 wird durch die Verstärker 37, 38 bewirkt, deren Ausgangssignale umgekehrte Vorzeichen aufweisen.

Die Abhängigkeit der Impedanzen Z_{E} und Z₁ von den Änderungen der Stellungen der Kondensatoren 9, 10 ist nicht orthogonal, d. h. die Änderung auch nur eines dieser Kondensatoren 9, 10 verändert beide Impedanzen Z_{E} und Z₁. Um die Kondensator-Verstellgeschwindigkeiten zu ermitteln, bei denen man auf dem kürzesten Weg zum Anpassungspunkt kommt, könnte man im Kennfeld von der Istposition aus eine Gerade durch den Anpassungspunkt legen. Jede Impedanzabweichung würde sich dann auf eine Linearkombination von Kondensatorgeschwindigkeiten abbilden. Da die Kennfelder jedoch nichtlinear sind und zudem von der Lastimpedanz 3 abhängen, wäre eine solche Vorgehensweise umständlich und aufwendig. Aus Kennfelddiagrammen für verschiedene Lastimpedanzen und Simulationsrechnungen hat sich ergeben, daß es einen günstigen Kompromiß darstellt, wenn die Regelgröße x₁ für den Kondensator 9 aus der Überlagerung beider Regelabweichungen im Regelgrößen-Bildner 34 gebildet wird, während die Regelgröße x₂ des Kondensators 10 direkt aus Z₁ abgeleitet und im Regelgrößen-Bildner 35 erzeugt wird. Da dieser Kompromiß nicht alle Zustände abdeckt, wurde der Regelgrößen-Bildner 36 vorgesehen, der bei Überschreiten eines Limits von Z_{E} verhindert, daß sich der Regler in einer Ecke der Stellbereiche festfährt.

Die Sollimpedanz Z_{E} ist reell 50 Ohm, während die Sollimpedanz Z₁ komplex ist. Da die Beträge der Ist-Impedanzen gebildet werden, müssen diese mit den Beträgen der Sollimpedanzen verglichen werden. Deshalb sind die Impedanzen in Fig. 2 mit Betragsstrichen versehen.

## Patentansprüche

1. Schaltungsanordnung zum automatischen Abstimmen eines Anpassungsnetzwerks (2), das zwischen einer elektrischen Energiequelle (1) und einer Last (3) angeordnet ist und das einstellbare Reaktanzen (9, 10) aufweist, mit
1.1 einem ersten Meßpunkt (17) im Anpassungsnetzwerk (2)
1.2 einem zweiten Meßpunkt (19) im Anpassungsnetzwerk (2)
1.3 einer Einrichtung (15) zum Erfassen eines ersten elektrischen Signals (U_{E}) an dem ersten Meßpunkt
1.4 einer Einrichtung (16) zum Erfassen eines zweiten elektrischen Signals (U₁) an dem zweiten Meßpunkt (19)
1.5 einer Einrichtung zum Zuführen des ersten elektrischen Signals (U_{E}) und des zweiten elektrischen Signals (U₁) zu einer Regel- und Recheneinheit (14),
und gekennzeichnet durch,
1.6 eine Komponente (4), die zwischen dem ersten Meßpunkt (17) und dem zweiten Meßpunkt (19) angeschlossen ist und
1.6.1 wobei ein drittes elektrisches Signal (I) in der Regel- und Recheneinrichtung (14) aus dem ersten elektrischen Signal (U_{E}) und dem zweiten elektrischen Signal (U₁) ermittelt wird
1.7 eine Einrichtung in der Regel- und Recheneinrichtung (14), die den absoluten Betrag des ersten elektrischen Signals (|U_{E}|), den absoluten Betrag des zweiten elektrischen Signals (|U₁|) und den absoluten Betrag des dritten elektrischen Signals (|I|) bildet
1.8 eine weitere Einrichtung (30, 31) in der Regel- und Recheneinrichtung (14), die wenigstens einen Impedanzwert (Z_{E}, Z₁) aus dem Absolutwert des ersten und des dritten elektrischen Signals bzw. aus dem zweiten und dritten elektrischen Signal bildet, und
1.9 eine Einrichtung (34, 35) zum Vergleichen des wenigstens einen Impedanzwerts mit einem vorgegebenen Sollwert dieses Impedanzwerts, wobei das Ergebnis des Vergleichs dazu verwendet wird, die Reaktanzen des Anpassungsnetzwerks (2) einzustellen.

2. Schaltungsanordnung nach Anspruch 1, **dadurch gekennzeichnet,** daß das erste elektrische Signal eine Eingangsspannung (U_{E}) des Anpassungsnetzwerks (2) ist.

3. Schaltungsanordnung nach Anspruch 1, **dadurch gekennzeichnet,** daß das zweite elektrische Signal eine Spannung (U₁) ist.

4. Schaltungsanordnung nach Anspruch 1, **dadurch gekennzeichnet,** daß das dritte elektrische Signal ein Eingangsstrom (I_{E}) des Anpassungsnetzwerks (2) ist, der durch die Berechnung der Differenz zwischen der Eingangsspannung (U_{E}) und der Spannung (U₁) am zweiten Meßpunkt ermittelt wird.

5. Schaltungsanordnung nach Anspruch 1, **dadurch gekennzeichnet,** daß die Rechen- und Regeleinheit (14) Stellmotoren (23, 24) antreibt, welche die einstellbaren Reaktanzen (9, 10) einstellt.

6. Schaltungsanordnung nach Anspruch 2, **dadurch gekennzeichnet,** daß die Eingangsspannung (U_{E}) einem ersten kapazitiven Aufnehmer (15) zugeführt und dann in die Rechen- und Regeleinheit (14) über ein erstes Bandpaßfilter (27) und einen ersten Gleichrichter (32) zu einem ersten Dividierer (30) gegeben wird.

7. Schaltungsanordnung nach Anspruch 3, **dadurch gekennzeichnet,** daß das zweite elektrische Signal (U₁) auf einen zweiten kapazitiven Aufnehmer (16) gegeben wird und dan in der Rechen- und Regeleinheit über ein zweites Bandpaßfilter (28) und einen zweiten Gleichrichter (33) zu einem zweiten Dividierer (31) gegeben wird.

8. Schaltungsanordnung nach Anspruch 4, **dadurch gekennzeichnet,** daß die Differenz zwischen dem ersten elektrischen Signal (U_{E}) und dem zweiten elektrischen Signal (U₁) mittels eines Subtrahierers (26) gebildet und über einen Gleichrichter (29) auf einen ersten Dividierer (30) und einen zweiten Dividierer (31) gegeben wird, wobei Subtrahierer (26), Gleichrichter (29) und Dividierer (30,31) Bestandteile der Rechen- und Regeleinheit (14) sind.

9. Schaltungsanordnung nach Anspruch 6 und Anspruch 8, **dadurch gekennzeichnet,** daß der erste Dividierer (30) den absoluten Wert einer der wenigstens einen Impedanz (|Z_{E}|) als Quotient aus dem absoluten Wert des ersten elektrischen Signals (|U_{E}|) und dem absoluten Wert des dritten elektrischen Signals (|I_{E}|) bildet.

10. Schaltungsanordnung nach Anspruch 7 oder Anspruch 8, **dadurch gekennzeichnet,** daß der zweite Dividierer (31) den absoluten Wert eines zweiten der wenigstens einen Impedanz (|Z₁|) aus dem absoluten Wert des zweiten elektrischen Signals (|U₁|) und dem absoluten Wert des dritten elektrischen Signals (|I_{E}|) bildet.

11. Schaltungsanordnung nach Anspruch 9, **dadurch gekennzeichnet,** daß ein erster Regelwertbildner (34) vorgesehen ist, der die Differenz zwischen dem absoluten Wert der einen der wenigstens einen Impedanz und dem absoluten Wert eines vorgegebenen Sollwerts für diese eine der wenigstens einen Impedanz bildet.

12. Schaltungsanordnung nach Anspruch 10**, dadurch gekennzeichnet,** daß ein zweiter Regelwertbildner (35) vorgesehen ist, der die Differenz zwischen dem absoluten Wert der zweiten der wenigstens einen Impedanz mit dem absoluten Wert eines vorgegebenen Sollwerts der zweiten der wenigstens einen Impedanz bildet.

13. Schaltungsanordnung nach Anspruch 9, **dadurch gekennzeichnet,** daß ein erster Regelwertbildner (34) vorgesehen ist, der die Differenz zwischen dem absoluten Wert der zweiten der wenigstens einen Impedanz und dem absoluten Wert eines vorgegebenen Werts für die zweite der wenigstens einen Impedanz bildet.

14. Schaltungsanordnung nach Anspruch 11, **dadurch gekennzeichnet,** daß der erste Regelwertbildner (34) auch die Differenz zwischen dem absoluten Wert einer zweiten der wenigstens einen Impedanz und dem absoluten Wert eines vorgegebenen Werts für die zweite der wenigstens einen Impedanz bildet.

15. Schaltungsanordnung nach Anspruch 9, **dadurch gekennzeichnet,** daß der absolute Wert der einen der wenigstens einen Impedanz (|Z_{E}|) auf einen Schwellwert-Erkenner (36) gegeben wird, der, nachdem er den absoluten Wert der einen der wenigstens einen Impedanz erkannt hat, die den absoluten Wert eines vorgegebenen Sollwerts für die eine der wenigstens einen Impedanz überschreitet, direkt die einstellbaren Reaktanzen (9, 10) des Anpassungsnetzwerks (2) einstellt

16. Schaltungsanordnung nach den Ansprüchen 11, 12 und 13, **dadurch gekennzeichnet,** daß die Ausgangssignale der Regelwertbildner (34, 35) über jeweils einen PID-Regler (41, 42) Stellmotoren (23, 24) zugeführt sind, welche Kondensatoren (9, 10) der Anpassungsschaltung (2) verstellen.

17. Schaltungsanordnung nach Anspruch 15, **dadurch gekennzeichnet,** daß der Wert eines (9) der Kondensatoren (9, 10) verringert und der Wert eines anderen (10) dieser Kondensatoren (9, 10) vergrößert wird.

18. Schaltungsanordnung nach Anspruch 1, **dadurch gekennzeichnet,** daß die Last (3) eine Plasmastrecke ist.

## Claims

1. A circuit arrangement for automatically tuning an adapter network (2) which is arranged between an electrical energy source (1) and a load (3) and has adjustable reactance elements (9, 10), having
1.1 a first measuring point (17) in the adapter network (2),
1.2 a second measuring point (19) in the adapter network (2),
1.3 a means (15) of detecting a first electrical signal (U_{E}) at the first measuring point,
1.4 a means (16) of detecting a second electrical signal (U₁) at the second measuring point (19),
1.5 a means of supplying the first electrical signal (U_{E}) and the second electrical signal (U₁) to a regulating and calculating unit (14),
and characterized by
1.6 a component (4) which is connected between the first measuring point (17) and the second measuring point (19),
1.6.1 a third electrical signal (I) in the regulating and calculating means (14) being determined from the first electrical signal (U_{E}) and the second electrical signal (U₁),
1.7 a means in the regulating and calculating means (14), which forms the modulus of the first electrical signal (|U_{E}|), the modulus of the second electrical signal (|U₁|) and the modulus of the third electrical signal (|I|),
1.8 a further means (30, 31) in the regulating and calculating means (14), which forms at least one impedance value (Z_{E}, Z₁) from the absolute value of the first and the third electrical signal or from the second and third electrical signal, and
1.9 a means (34, 35) for comparing the at least one impedance value with a predetermined set value of this impedance value, the result of the comparison being used to adjust the reactance elements of the adapter network (2).

2. A circuit arrangement according to Claim 1, characterized in that the first electrical signal is an input voltage (U_{E}) of the adapter network (2).

3. A circuit arrangement according to Claim 1, characterized in that the second electrical signal is a voltage (U₁).

4. A circuit arrangement according to Claim 1, characterized in that the third electrical signal is an input current (I_{E}) of the adapter network (2) which is determined by calculating the difference between the input voltage (U_{E}) and the voltage (U₁) at the second measuring point.

5. A circuit arrangement according to Claim 1, characterized in that the calculating and regulating unit (14) drives servo motors (23, 24) which adjust the adjustable reactance elements (9, 10).

6. A circuit arrangement according to Claim 2, characterized in that the input voltage (U_{E}) is supplied to a first capacitive pick-up (15) and is then passed into the calculating and regulating unit (14) by way of a first bandpass filter (27) and a first rectifier (32) to a first divider (30).

7. A circuit arrangement according to Claim 3, characterized in that the second electrical signal (U₁) is passed to a second capacitive pick-up (16) and is then passed into the calculating and regulating unit by way of a second bandpass filter (28) and a second rectifier (33) to a second divider (31).

8. A circuit arrangement according to Claim 4, characterized in that the difference between the first electrical signal (U_{E}) and the second electrical signal (U₁) is formed by means of a subtracter (26) and is passed by way of a rectifier (29) to a first divider (30) and a second divider (31), the subtracter (26), rectifier (29) and dividers (30, 31) being components of the calculating and regulating unit (14).

9. A circuit arrangement according to Claim 6 and Claim 8, characterized in that the first divider (30) forms the absolute value of one of the at least one impedance (|Z_{E}|) as the quotient of the absolute value of the first electrical signal (|U_{E}|) and the absolute value of the third electrical signal (|I_{E}|).

10. A circuit arrangement according to Claim 7 or Claim 8, characterized in that the second divider (31) forms the absolute value of a second of the at least one impedance (|Z₁|) from the absolute value of the second electrical signal (|U₁|) and the absolute value of the third electrical signal (|I_{E}|).

11. A circuit arrangement according to Claim 9, characterized in that a first regulating value former (34) is provided which forms the difference between the absolute value of the one of the at least one impedance and the absolute value of a predetermined set value for this one of the at least one impedance.

12. A circuit arrangement according to Claim 10, characterized in that a second regulating value former (35) is provided which forms the difference between the absolute value of the second of the at least one impedance and the absolute value of a predetermined set value of the second of the at least one impedance.

13. A circuit arrangement according to Claim 9, characterized in that a first regulating value former (34) is provided which forms the difference between the absolute value of the second of the at least one impedance and the absolute value of a predetermined value for the second of the at least one impedance.

14. A circuit arrangement according to Claim 11, characterized in that the first regulating value former (34) also forms the difference between the absolute value of a second of the at least one impedance and the absolute value of a predetermined value for the second of the at least one impedance.

15. A circuit arrangement according to Claim 9, characterized in that the absolute value of the one of the at least one impedance (|Z_{E}|) is passed to a threshold value recognition means (36) which, once it has recognized the absolute value of the one of the at least one impedance which exceeds the absolute value of a predetermined set value for the one of the at least one impedance, adjusts the adjustable reactance elements (9, 10) of the adapter network (2) directly.

16. A circuit arrangement according to Claims 11, 12 and 13, characterized in that the output signals from the regulating value formers (34, 35) are supplied by way of a respective PID regulator (41, 42) to servo motors (23, 24) which set capacitors (9, 10) of the adapter circuit (2).

17. A circuit arrangement according to Claim 15, characterized in that the value of one (9) of the capacitors (9, 10) is reduced and the value of another (10) of these capacitors (9, 10) is increased.

18. A circuit arrangement according to Claim 1, characterized in that the load (3) is a plasma channel.

## Revendications

1. Disposition en circuit pour l'accord automatique d'un réseau d'adaptation (2), qui est disposé entre une source électrique d'énergie (1) et une charge (3) et qui présente une réactance réglable (9, 10), comprenant
1.1 un premier point de mesure (17) dans le réseau d'adaptation (2)
1.2 un second point de mesure (19) dans le réseau d'adaptation (2)
1.3 un dispositif (15) pour la saisie d'un premier signal électrique (U_{E}) au premier point de mesure
1.4 un dispositif (16) pour la saisie d'un second signal électrique (U₁) au second point de mesure (19).
1.5 un dispositif pour l'amenée du premier signal électrique (U_{E}) et du second signal électrique (U₁) à une unité de réglage et de calcul (14), disposition caractérisée par
1.6 un composant (4) qui est raccordé entre le premier point de mesure (17) et le second point de mesure (19) et
1.6.1 un troisième signal électrique (I) étant déterminé dans le dispositif de réglage et de calcul (14) à partir du premier signal électrique (U_{E}) et du second signal électrique (U₁),
1.7 un dispositif dans l'unité de calcul et de réglage (14), qui forme la valeur absolue du premier signal électrique (|U_{E}|), la valeur absolue du second signal électrique (|U₁|) et la valeur absolue du troisième signal électrique (|I|)
1.8 un autre dispositif (30, 31) dans l'unité de calcul et de réglage (14), qui forme au moins une valeur d'impédance (Z_{E}, Z₁) à partir de la valeur absolue du premier et du troisième signal respectivement, à partir du second et du troisième signal électrique, et
1.9 un dispositif (34, 35) pour la comparaison d'au moins une valeur d'impédance avec une valeur de consigne prédéterminée de cette valeur d'impédance, le résultat de la comparaison étant utilisé pour régler les réactances du réseau d'adaptation (2).

2. Disposition en circuit selon la revendication 1, caractérisée en ce que le premier signal électrique est une tension d'entrée (U_{E}) du réseau d'adaptation (2).

3. Disposition en circuit selon la revendication 1, caractérisée en ce que le second signal électrique est une tension (U₁).

4. Disposition en circuit selon la revendication 1, caractérisée en ce que le troisième signal électrique est un courant d'entrée (I_{E}) du réseau d'adaptation (2), qui est déterminé par le calcul de la différence entre la tension d'entrée (U_{E}) et la tension (U₁) au second point de mesure.

5. Disposition en circuit selon la revendication 1, caractérisée en ce que l'unité de réglage et de calcul (14) entraîne des moteurs de réglage (23, 24) qui règlent les réactances réglables (9, 10).

6. Disposition en circuit selon la revendication 2, caractérisée en ce que la tension d'entrée (U_{E}) est amenée à un premier capteur capacitif (15) et est ensuite délivrée, dans l'unité de calcul et de réglage (14), par l'intermédiaire d'un premier filtre passe-bas (27) et d'un premier redresseur (32) à un premier diviseur (30).

7. Disposition en circuit selon la revendication 3, caractérisée en ce que le second signal électrique (U₁) est délivré à un second capteur capacitif (16) et ensuite est délivré, dans l'unité de calcul et de réglage, par l'intermédiaire d'un second filtre passe-bas (28) et d'un second redresseur (33) à un second diviseur (31).

8. Disposition en circuit selon la revendication 4, caractérisée en ce que la différence entre le premier signal électrique (U_{E}) et le second signal électrique (U₁) est formée au moyen d'un soustracteur (26) et est délivrée par l'intermédiaire d'un redresseur (29) à un premier diviseur (30) et à un second diviseur (31), le soustracteur (26), le redresseur (29) et les diviseurs (30, 31) étant des parties constituantes de l'unité de calcul et de réglage (14).

9. Disposition en circuit selon la revendication 6 et la revendication 8, caractérisée en ce que le premier diviseur (30) forme la valeur absolue d'au moins une impédance (|Z_{E}|) en tant que quotient à partir de la valeur absolue du premier signal électrique (|U_{E}|) et de la valeur absolue du troisième signal électrique (|I_{E}|).

10. Disposition en circuit selon la revendication 7 ou la revendication 8, caractérisée en ce que le second diviseur (31) forme la valeur absolue d'au moins une impédance (|Z₁|) à partir de la valeur absolue du second signal électrique (U₁) et de la valeur absolue du troisième signal électrique (|I_{E}|).

11. Disposition en circuit selon la revendication 9, caractérisée en ce qu'il est prévu un premier élaborateur de valeur de réglage (34) qui forme la différence entre la valeur absolue de la première d'au moins une impédance et la valeur absolue d'une valeur de consigne prédéterminée de la première d'au moins une impédance.

12. Disposition en circuit selon la revendication 10, caractérisée en ce qu'il est prévu un second élaborateur de valeur de réglage (35) qui forme la différence entre la valeur absolue de la seconde d'au moins une impédance et la valeur absolue d'une valeur de consigne prédéterminée de la seconde d'au moins une impédance.

13. Disposition en circuit selon la revendication 9, caractérisée en ce qu'il est prévu un premier élaborateur de valeur de réglage (34) qui forme la différence entre la valeur absolue de la seconde d'au moins une impédance et la valeur absolue d'une valeur de consigne prédéterminée de la seconde d'au moins une impédance.

14. Disposition en circuit selon la revendication 11, caractérisée en ce que le premier élaborateur de valeur de réglage (34) forme également la différence entre la valeur absolue d'une seconde d'au moins une impédance et la valeur absolue d'une valeur prédéterminée de la seconde d'au moins une impédance.

15. Disposition en circuit selon la revendication 9, caractérisée en ce que la valeur absolue de la première d'au moins une impédance (|Z_{E}|) est délivrée à un détecteur de valeur seuil (36) qui, après avoir reconnu la valeur absolue de la première d'au moins une impédance qui dépasse la valeur absolue d'une valeur de consigne prédéterminée de la première d'au moins une impédance, règle directement les réactances réglables (9, 10) du réseau d'adaptation (2).

16. Disposition en circuit selon les revendications 11, 12 et 13, caractérisée en ce que les signaux de sortie des élaborateurs de valeur de réglage (34, 35) sont amenés respectivement, par l'intermédiaire d'un régulateur P.I.D (41, 42) à des moteurs de réglage (23, 24) qui règlent les condensateurs (9, 10) du circuit d'adaptation (2).

17. Disposition en circuit selon la revendication 15, caractérisée en ce que la valeur de l'un (9) des condensateurs (9, 10) diminue et la valeur d'un autre (10) de ces condensateurs (9, 10) augmente.

18. Disposition en circuit selon la revendication 1, caractérisée en ce que la charge (3) est une trajectoire de plasma.
